(19) Europäisches Patentamt / European Patent Office / Office européen des brevets

(11) EP 3 731 018 A1

(12) EUROPEAN PATENT APPLICATION

(43) Date of publication:
28.10.2020 Bulletin 2020/44

(51) Int Cl.:
$G03F\ 7/20^{(2006.01)}$     $G01B\ 11/06^{(2006.01)}$

(21) Application number: 19170674.6

(22) Date of filing: 23.04.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventor: TINNEMANS, Patricius Aloysius
Jacobus
5500 AH Veldhoven (NL)

(74) Representative: ASML Netherlands B.V.
Corporate Intellectual Property
P.O. Box 324
5500 AH Veldhoven (NL)

(54) **A METHOD FOR RE-IMAGING AN IMAGE AND ASSOCIATED METROLOGY APPARATUS**

(57)     Disclosed is a method for re-imaging an image to correspond to a desired illumination scheme. The method comprises obtaining a first image corresponding to a first illumination scheme and convolving the first image with a Fourier transform of an incident mutual intensity function describing the desired illumination scheme to obtain a reimaged image corresponding to the desired illumination scheme.

(a)

Fig. 6

**Description**

FIELD

The present invention relates to a metrology apparatus or an inspection apparatus for determining a characteristic of structures on a substrate. The present invention also relates to a method for determining a characteristic of structures on a substrate.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable to make frequently measurements of the structures created, e.g., for process control and verification. Various tools for making such measurements are known, including scanning electron microscopes or various forms of metrology apparatuses, such as scatterometers. A general term to refer to such tools may be metrology apparatuses or inspection apparatuses.

When measuring with a metrology device having a small illumination NA, crosstalk from structures (e.g., product structures) adjacent the target being measured has a bigger impact on the measurement.

SUMMARY

It is an object to provide an effective an efficient solution for an inspection or metrology apparatus to help minimize measurement crosstalk between structures.

Embodiments of the invention are disclosed in the claims and in the detailed description.

In a first aspect of the invention there is provided a method for re-imaging an image to correspond to a desired illumination scheme. The method comprises obtaining a first image corresponding to a first illumination scheme and convolving the first image with a Fourier transform of an incident mutual intensity function describing the desired illumination scheme to obtain a reimaged image corresponding to the desired illumination scheme.

In a second aspect of the invention there is provided a metrology apparatus comprising: an optical system for capturing diffracted radiation from a target structure;

a detector operable to detect said diffracted radiation as a first image corresponding to a first illumination scheme; and a processor operable to convolve the first image with a Fourier transform of an incident mutual intensity function describing a desired illumination scheme to obtain a reimaged image corresponding to the desired illumination scheme.

Also provided is a computer program product operable to carry out the method of the first aspect.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 illustrates an inspection apparatus according to an embodiment of the invention;
- Figure 5 comprises (a) a schematic diagram of a dark field scatterometer for use in measuring targets using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 depicts a metrology apparatus in according to an embodiment of the invention in (a) a first measurement configuration and (b) a second measurement configuration.

DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

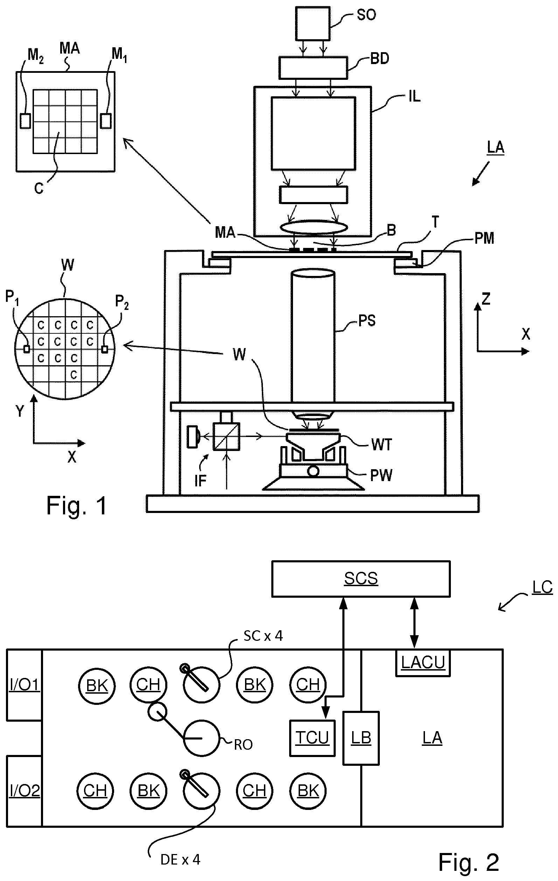

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

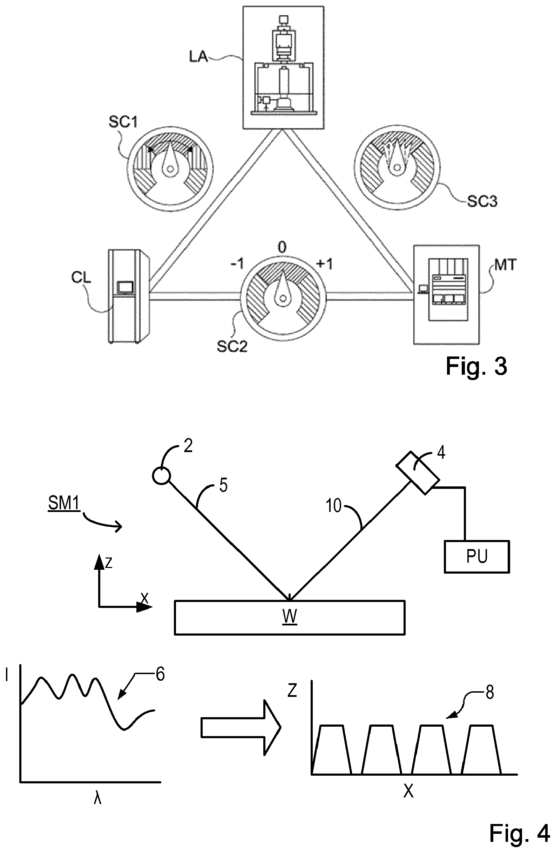

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MET (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MET may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating can be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers can measure in one image multiple targets from multiple gratings using light from soft x-ray and visible to near-IR wave range.

A metrology apparatus, such as a scatterometer, is depicted in Figure 4. It comprises a broadband (white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength $\lambda$) of the specular reflected radiation 10. From this data, the structure or profile 8 giving rise to the detected spectrum may be reconstructed by processing unit PU, e.g. by Rigorous Coupled Wave Analysis and non-linear regression or by comparison with a library of simulated spectra. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

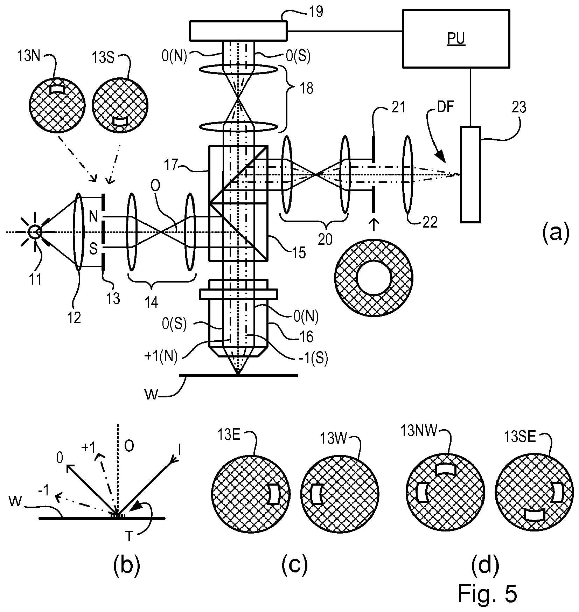

A metrology apparatus suitable for use in embodiments of the invention is shown in Figure 5(a). Note that this is only one example of a suitable metrology apparatus. An alternative suitable metrology apparatus may use EUV radiation such as, for example, that disclosed in WO2017/186483A1 (which is incorporated herein by reference in its entirety). A target structure T and diffracted rays of measurement radiation used to illuminate the target structure are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target structure T is placed with substrate W normal to the optical axis O of objective lens 16. The substrate W may be supported by a support (not shown). A ray of measurement radiation I impinging on target structure T from an angle off the axis O gives rise to a zeroth order ray (solid line 0) and two first order rays (dot-chain line +1 and double dot-chain line -1). It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d). The use of these, and numerous other variations and applications of the apparatus are described in prior published applications, mentioned above.

The imaging optics of the metrology tool of the type shown in Figure 5 are extremely complicated with low tolerances and high aberration requirements. To relax these requirements, Computational Imaging (CI) techniques have been described, such as in Patent application EP17199764.6 filed Nov 2, 2017 or Patent application EP18158745.2 filed Feb 27, 2018 which are incorporated herein by reference. In CI, the high-quality and high-NA imaging optics of a typical metrology device are replaced by a simple single lens, for example, which creates a relatively distorted and/or aberrated image of the metrology target(s) on an image sensor. A near-perfect image of metrology targets can be retrieved when the full field (both intensity and phase) of the light on the sensor is known by direct phase resolved measurements (e.g. holographic microscopy) or by phase retrieval methods (phase is retrieved from intensity measurements only) or by hybrid combinations of thereof. In phase resolved measurements, the full electric field on the sensor can be observed by using a holographic setup and applied knowledge regarding the imaging system. Phase retrieval methods may use a phase retrieval algorithm and prior knowledge relating to the imaging system and/or the metrology targets. Examples of suitable phase retrieval methods have been described in the aforementioned patent application EP17199764.6 filed on November 2, 2017.

A metrology tool of the type shown in Figure 5 may use partially spatially coherent (or even incoherent) illumination. In a Computational Imaging (CI) based sensor such as described above, it is proposed that (at least nearly) fully spatially coherent illumination may be used. However, spatially coherent radiation has the drawback of increased crosstalk between product structures and the target being measured. This increased crosstalk results in a reduced process variation robustness, in the absence of any mitigation strategies.

To appreciate this crosstalk issue, it should be appreciated that fully spatially coherent illumination results in a larger effective point spread function (i.e., the point spread function is larger and decays less rapidly and additionally, all fields are added in amplitude but less so in intensity). This increases the crosstalk from neighboring customer structures to the targets (e.g., overlay or focus targets).

To address this crosstalk issue, it is proposed to perform a measurement using a spatially coherent illumination scheme (in this context "spatially coherent" means either fully or near fully spatially coherent, where near fully spatially coherent describes a level of coherence sufficient to reduce the crosstalk between targets, target sections, or from neighboring structures to the target (sections). The resultant image (a first image) from this spatially coherent measurement is then convolved with a suitable Fourier transform to obtain a reimaged image which is equivalent to that which would have been obtained using an alternative, desired illumination scheme. The desired illumination scheme might be, for example an illumination scheme presently used on a tool such as illustrated in Figure 5 (e.g., partially spatially coherent radiation) or spatially incoherent radiation, for example. The suitable Fourier transform comprises the Fourier transform of the mutual intensity function describing the alternative (desired) illumination scheme.

As such, it will be described how to re-image a partial coherent intensity image as a convolution between the intensity image formed by a single plane wave illumination (spatially coherent first image) and the Fourier transform of the incident mutual intensity function of a desired illumination scheme. For such a convolution to be valid, the measurement should be performed in the paraxial regime, or else the measurement should first be computationally propagated from a non-paraxial to a paraxial regime (for example by computationally introducing a suitable magnification in this propagation).

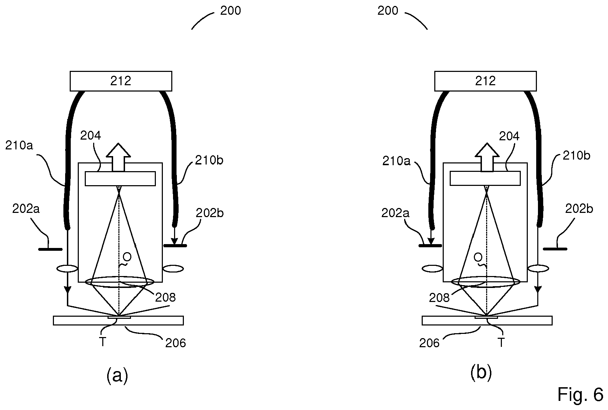

Figures 6a and 6b show simplified schematic representations of a metrology tool 200. One or more of the features of the metrology tool 100 described with respect to Figures 4 or 5 may also be present in the metrology tool 200 as appropriate and these are not described again here in detail. It is proposed, in an embodiment, that such an arrangement be used in combination with a computational imaging based sensor as described above. However, this is not essential, as will be described.

Such a metrology tool 200 is operable in the paraxial regime, where the diffracted radiation is close to the parallel with the optical axis O of the system, such that the diffracted rays make a small angle with respect to this optical axis O (this angle is exaggerated in the drawings for clarity). Small angle in this context may be, for example, angles smaller than smaller than 10 degrees or smaller than 5 degrees.

The metrology tool 200 comprises a shutter in at least one of the optical paths of the illumination optical system. In the example of Figures 6a and 6b, there are two optical paths, each receiving radiation from radiation source 212 via respective illumination fiber 210a, 210b, and each optical path comprises a shutter 202a, 202b. In known exemplary arrangements, mechanical shutters are used. Such shutters typically have a switching speed (i.e. the time required to open or close the shutter) in the order of milliseconds.

The metrology tool 200 also comprises an optical sensor 204. The optical sensor 204 is positioned in the detection optical system and may therefore be termed a detection optical sensor. In some arrangements, the metrology tool 200 may also comprise features similar to or the same as the focusing optical sensors 120, 144. In exemplary arrangements, the optical sensor 204 may be a high-speed CMOS camera with at least 1000 frames per second.

As shown in Figures 6a and 6b, the metrology tool 200 may operate by sequential opening and closing of the shutters 202a, 202b to direct illumination radiation from alternate directions onto a structure or target T, on a substrate 206. Resultant diffraction orders are collected through the lens 208 and onto the optical sensor 204. This allows sequential measurement images to be captured, a measurement image being one formed on the detection optical sensor 204. Figure 6a represents the configuration capturing the first measurement image and Figure 6b represents the configuration capturing the second measurement image some time later. In exemplary arrangements, the illuminating radiation through a first shutter 202a provides the first measurement image of a target T comprising +1st order diffracted radiation, and the illuminating radiation through a second shutter 202b provides the second measurement image of the same target T comprising -1st order diffracted radiation. The sequential images may be used by a processing unit to determine a parameter of the structure T.

The switching between the two measurements may be enabled by means of illumination switching instead of shutters 202a, 202b. For example. The illumination source 212 may comprise, for example, a broadband source such as a high brightness supercontinuum light source. Such a source may have a range over 1000 or 1500nm wide, for example between <350-2000nm. The switching may be implemented by a switching module implemented within illumination source 212 or between the illumination source 212 and illumination fibers 210a, 210b. Switching module 214 may, for example, enable wavelength selection, with sub-millisecond wavelength switching.

Where optical sensor 204 comprises a computational imaging based sensor, the lens 208 may be relatively simple compared to the equivalent projection optics of the apparatus illustrated, for example, in Figure 5.

An advantage of the paraxial regime is that the paraxial approximation is applicable (Gaussian optics approximation); i.e., the approximations: $\sin\theta \approx \theta$, $\tan\theta \approx \theta$ and $\cos\theta \approx 1$. In general, the accuracies required in semiconductor control metrology tends to mean that any approximations such as these are undesirable, as a starting point.

In a proposed embodiment of the computational imaging based sensor (e.g., implemented as part of a metrology tool 200), a sufficiently large magnification may be used such that, at the sensor plane, the optical fields can be approximated with (sufficiently) good quality by the paraxial approximation. The sufficiently large magnification may be at least 10x, at least 20x, at least 30x, at least 40x or at least 50x for example. In the paraxial regime, the propagation of the optical fields is simpler to model, which can be exploited in reducing the computational complexity inherent in a Computational Imaging functionality.

In a proposed computational imaging sensor, the illumination and detection optics are separated so as to reduce complexity and eliminate ghosting and stray light. This requires the illumination numerical aperture to be small, which means that the spatial coherence of the illumination is large (i.e. close to fully coherent, which is equivalent to single plane wave illumination).

According to an embodiment, the metrology tool 200 as presented in Figure 6 can be used to measure an image in terms of an intensity distribution $P_i(r,z,\lambda)$ using a (near) full spatial coherent illumination (i.e. illumination of the target with one single plane wave). This measured image $P_i(r,z,\lambda)$ is then convolved with the Fourier transform of the mutual intensity function of the desired illumination scheme $F_i(r/z,\lambda)$ to obtain a version of the image $I(r,z,\lambda)$ (in terms of intensity at the detection plane) corresponding to the desired illumination scheme (e.g., an image as if it had been measured using the desired illumination scheme). As stated already, a desired illumination scheme may correspond to use of spatially partially coherent or incoherent radiation. The convolution is described by Equation (1):

$$I(\boldsymbol{r}, z, \lambda) = B_i(\boldsymbol{r}/z, \lambda) ** P_i(\boldsymbol{r}, z, \lambda) \qquad \text{Equation (1)}$$

where, $\lambda$ is the wavelength of the radiation, z is the distance along the optical axis between the aperture plane and detector plane and $\boldsymbol{r}$ is the off axis location (in both x and/or y). The operator ** denotes a two dimensional convolution over $\boldsymbol{r}$.

Equation (1) is a generalization of Schell's theorem, and may be stated in words as follows: for a source with spatially stationary statistics, the optical intensity of the diffraction pattern produced by an aperture is the convolution of the Fourier transform of the mutual intensity function with the aperture's incoherent point spread function for a source at infinity.

In effect, Equation (1) makes it possible to computationally implement a programmable flexible illuminator. Note that the computation in the form of Equation (1) can be implemented relatively cheaply.

It should be appreciated that, for measurement using a tool such as illustrated in Figure 5 using partially spatially coherent illumination, the target is illuminated by a multitude/summation of plane waves from different angles, while in the computational imaging sensor measurement the target is illuminated from (far) fewer different angles. While this is not a problem in itself, it does mean that the re-imaged image $I(r,z,\lambda)$ cannot be made to correspond identically to an image obtained via a Figure 5 apparatus. However, the aim here is to achieve a similar (or possibly better) suppression of the crosstalk in between the product structures and the target being measured, compared to a tool which uses partially spatially coherent illumination.

The provision of a computer programmable flexible illumination scheme opens up other possibilities. As there is more freedom in a computer programmable flexible illumination scheme, the illumination can be made more application specific. This could, for example, enable improvement of the crosstalk suppression beyond that observed presently (e.g., using a Figure 5-type arrangement and partially spatially coherent illumination).

The above description has been described predominately in the context of using a computational imaging sensor. However, particular for larger wavelengths, a (near) diffraction limited imaging performance (at a numerical aperture of about 0.5 for example) may be achievable without the need for computational image processing, for example by imaging via a single bi-aspherical lens (note that as the wavelength increases, the aberrations have the tendency to reduce, because they are expressed in waves). As such, for larger wavelengths in particular, a computational aberration correction may not be necessary.

By using methods and apparatuses described herein, any parameter of interest can be calculated, such as overlay. Other than the step of computationally deriving the interference electric field rather than sensing an actual interference field directly using a sensor, otherwise conventional methods for determining overlay may be employed. One such conventional method, for example, may comprise determining (computationally) the intensities of corresponding diffraction orders (for example +1 order and -1 order although a pair of higher orders can also be used) and then the intensity asymmetry (e.g., their difference) from the computationally determined interference electric field. More specifically, intensity asymmetry may be measured in this way from two or more pairs of structures (e.g. two grating pairs or targets with a different imposed bias), so as to determine the overlay sensitivity (the relationship between intensity asymmetry and overlay). Such methods are known and are described, for example, in WO2015/018625, incorporated herein by reference. However, the methods also allow improved methods for calculating overlay to be employed.

Any method for measuring or extracting the required relative (or absolute) phases may be used in the above computational imaging based methods. A few example measurement schemes will now be described, by way of example. In each case, spatially (partial) coherent illumination should be used.

A computational imaging/phase retrieval approach may be employed. In such an approach, the intensity and phase of the target is retrieved from one or multiple intensity measurements of the target. The phase retrieval may use prior information of the metrology target (e.g., for inclusion in a loss function that forms the starting point to derive/design the phase retrieval algorithm). Alternatively, or in combination with the prior information approach, diversity measurements may be made. To achieve diversity, the imaging system is slightly altered between the measurements. An example of a diversity measurement is through-focus stepping, i.e., by obtaining measurements at different focus positions. Alternative methods for introducing diversity include, for example, using different illumination wavelengths or a different wavelength range, modulating the illumination, or changing the angle of incidence of the illumination on the target between measurements.

While the above examples are described in terms of overlay, the invention is equally applicable to any metrology (e.g., based on measuring asymmetry in a structure), such as a target, comprising (at least) two gratings. While overlay is one example of a characteristic of interest which can be measured in this way, other examples may comprise focus and/or dose. These can be measured, for example, from targets which are exposed with a focus or dose dependent asymmetry which can be measured back and the exposure focus position and/or dose determined therefrom. Another example of a characteristic of interest for which the concepts herein are applicable is EPE (Edge Placement Error), which is a more complex form of overlay (e.g., a combination of overlay and critical dimension uniformity).

Further embodiments are disclosed in the subsequent numbered clauses:

1. A method for re-imaging an image to correspond to a desired illumination scheme, the method comprising:

obtaining a first image corresponding to a first illumination scheme, and
convolving the first image with a Fourier transform of an incident mutual intensity function describing the desired illumination scheme to obtain a reimaged image corresponding to the desired illumination scheme.

2. A method as defined in clause 1, wherein the first illumination scheme is an at least near spatially coherent illumination scheme.

3. A method as defined in clause 2, wherein said first image is assumed to have been formed by a single plane wave illumination.

4. A method as defined in any preceding clause, wherein the first image has been obtained via a measurement performed in a paraxial regime.

5. A method as defined in any preceding clause, the desired illumination scheme is an illumination scheme which is less spatially coherent relative to the first illumination scheme.

6. A method as defined in any preceding clause, wherein the desired illumination scheme is a partially spatially coherent illumination scheme or a spatially incoherent illumination scheme.

7. A method as defined in any preceding clause, wherein the first image and reimaged imaged are each described in terms of a respective intensity distribution.

8. A method as defined in clause 7, wherein said intensity distributions comprise intensity distributions relating to a higher diffraction order of diffracted radiation from a target structure.

9. A method as defined in any preceding clause, wherein at least the first image is computationally processed to retrieve phase.

10. A method as defined in clause 9, wherein the first image has been captured via a sensor having aberrations, and said retrieved phase is used to compensate for the aberrations.

11. A method as defined in any preceding clause, wherein the desired illumination scheme is optimized according to a particular application, so as to minimize crosstalk between the target structure being measured and any surrounding structure.

12. A metrology apparatus comprising:

an optical system for capturing diffracted radiation from a target structure;
a detector operable to detect said diffracted radiation as a first image corresponding to a first illumination scheme; and
a processor operable to convolve the first image with a Fourier transform of an incident mutual intensity function describing a desired illumination scheme to obtain a reimaged image corresponding to the desired illumination scheme.

13. A metrology apparatus as defined in clause 12, wherein the metrology apparatus comprises a paraxial metrology apparatus arranged such that the diffracted rays make a small angle with respect to an optical axis of the metrology apparatus.

14. A metrology apparatus as defined in clause 12 or 13, comprising an illumination numerical aperture resulting in the first illumination scheme being an at least near spatially coherent illumination scheme.

15. A metrology apparatus as defined in clauses 12, 13 or 14 wherein the optical system imposes a magnification of more than 30 times.

16. A metrology apparatus as defined in any of clauses 12 to 15, the desired illumination scheme is an illumination scheme which is less spatially coherent relative to the first illumination scheme.

17. A metrology apparatus as defined in any of clauses 12 to 16, wherein the desired illumination scheme is a partially spatially coherent illumination scheme or a spatially incoherent illumination scheme.

18. A metrology apparatus as defined in any of clauses 12 to 17, wherein the first image and reimaged imaged are each described in terms of a respective intensity distribution.

19. A metrology apparatus as defined in clause 18, wherein said intensity distributions comprise intensity distributions relating to a higher diffraction order of diffracted radiation from the target structure.

20. A metrology apparatus as defined in any of clauses 12 to 19, wherein the processor is operable to computationally process the first image to retrieve phase.

21. A metrology apparatus as defined in clause 20 wherein the optical system comprises aberrations, and said retrieved phase is used to compensate for the aberrations.

22. A metrology apparatus as defined in any of clauses 12 to 21, wherein the processor is operable to optimize the desired illumination scheme according to a particular application, so as to minimize crosstalk between the target structure being measured and any surrounding structure.

23. A metrology apparatus as defined in any of clauses 12 to 22, wherein the processor is operable to implement a programmable flexible illuminator.

24. A computer program product comprising machine-readable instructions for causing a processor to cause performance of the method as defined in any of clauses 1 to 11.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of an inspection or metrology apparatus, embodiments of the invention may be used in other apparatus. Embodiments of the invention may form part of a mask inspection apparatus, a lithographic apparatus, or any apparatus that measures or processes an object such as a wafer (or other substrate) or mask (or other patterning device). The term "metrology apparatus" may also refer to an inspection apparatus or an inspection system. E.g. the inspection apparatus that comprises an embodiment of the invention may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments of the invention in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch P of the metrology targets may be close to the resolution limit of the optical system of the scatterometer or may be smaller, but may be much larger than the dimension of typical product features made by lithographic process in the target portions C. In practice the lines and/or spaces of the overlay gratings within the target structures may be made to include smaller structures similar in dimension to the product features.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method for re-imaging an image to correspond to a desired illumination scheme, the method comprising:

   obtaining a first image corresponding to a first illumination scheme, and
   convolving the first image with a Fourier transform of an incident mutual intensity function describing the desired illumination scheme to obtain a reimaged image corresponding to the desired illumination scheme.

**2.** A method as claimed in claim 1, wherein the first illumination scheme is an at least near spatially coherent illumination scheme.

**3.** A method as claimed in claim 2, wherein said first image is assumed to have been formed by a single plane wave illumination.

**4.** A method as claimed in any preceding claim, wherein the first image has been obtained via a measurement performed in a paraxial regime.

**5.** A method as claimed in any preceding claim, the desired illumination scheme is an illumination scheme which is less spatially coherent relative to the first illumination scheme.

**6.** A method as claimed in any preceding claim, wherein the desired illumination scheme is a partially spatially coherent illumination scheme or a spatially incoherent illumination scheme.

**7.** A method as claimed in any preceding claim, wherein the first image and reimaged imaged are each described in terms of a respective intensity distribution.

**8.** A method as claimed in claim 7, wherein said intensity distributions comprise intensity distributions relating to a higher diffraction order of diffracted radiation from a target structure.

**9.** A method as claimed in any preceding claim, wherein at least the first image is computationally processed to retrieve phase.

**10.** A method as claimed in claim 9, wherein the first image has been captured via a sensor having aberrations, and said retrieved phase is used to compensate for the aberrations.

**11.** A method as claimed in any preceding claim, wherein the desired illumination scheme is optimized according to a particular application, so as to minimize crosstalk between the target structure being measured and any surrounding structure.

**12.** A metrology apparatus comprising:

an optical system for capturing diffracted radiation from a target structure;
a detector operable to detect said diffracted radiation as a first image corresponding to a first illumination scheme; and
a processor operable to convolve the first image with a Fourier transform of an incident mutual intensity function describing a desired illumination scheme to obtain a reimaged image corresponding to the desired illumination scheme.

**13.** A metrology apparatus as claimed in claim 12, wherein the metrology apparatus comprises a paraxial metrology apparatus arranged such that the diffracted rays make a small angle with respect to an optical axis of the metrology apparatus.

**14.** A metrology apparatus as claimed in any of claims 12 to 13, wherein the processor is operable to optimize the desired illumination scheme according to a particular application, so as to minimize crosstalk between the target structure being measured and any surrounding structure.

**15.** A computer program product comprising machine-readable instructions for causing a processor to cause performance of the method as claimed in any of claims 1 to 11.

Fig. 1

Fig. 2

LA

SC1

SC3

CL

MT

0

-1      +1

SC2

Fig. 3

2

4

SM1

5

10

PU

Z

X

W

I

6

λ

Z

8

X

Fig. 4

Fig. 5

Fig. 6

Europäisches
Patentamt

European
Patent Office

Office européen
des brevets

# EUROPEAN SEARCH REPORT

Application Number

EP 19 17 0674

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/107781 A1 (TINNEMANS PATRICIUS ALOYSIUS JACOBUS [NL] ET AL) 11 April 2019 (2019-04-11) | 1-3, 5-12,14, 15 | INV. G03F7/20 G01B11/06 |
| Y | * paragraphs [0059] - [0096], [0225], [0226] * | 4,13 | |
| X | PATI Y C ET AL: "Exploiting Structure in Fast Aerial Image Computation for Integrated Circuit Patterns", IEEE TRANSACTIONS ON SEMICONDUCTOR MANUFACTURING, IEEE SERVICE CENTER, PISCATAWAY, NJ, US, vol. 10, no. 1, 1 February 1997 (1997-02-01), XP011055616, ISSN: 0894-6507 * section: "Introduction" and "Summary and Conclusions" * | 1 | |
| X | US 2008/127027 A1 (GALLATIN GREGG M [US] ET AL) 29 May 2008 (2008-05-29) * paragraphs [0068] - [0084] * | 1 | |
| X | US 2005/149902 A1 (SHI XUELONG [US] ET AL) 7 July 2005 (2005-07-07) * paragraphs [0052], [0068] * | 1 | TECHNICAL FIELDS SEARCHED (IPC) G03F G01B |
| Y | US 2005/015233 A1 (GORDON RONALD L [US]) 20 January 2005 (2005-01-20) * paragraphs [0027] - [0030] * | 4,13 | |

The present search report has been drawn up for all claims

| Place of search | Date of completion of the search | Examiner |
|---|---|---|
| Munich | 10 October 2019 | Eisner, Klaus |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 19 17 0674

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2019

| Patent document cited in search report | | Publication date | Patent family member(s) | | Publication date |
|---|---|---|---|---|---|
| US 2019107781 | A1 | 11-04-2019 | TW 201925922 A | | 01-07-2019 |
| | | | US 2019107781 A1 | | 11-04-2019 |
| | | | WO 2019068459 A1 | | 11-04-2019 |
| US 2008127027 | A1 | 29-05-2008 | AT 519169 T | | 15-08-2011 |
| | | | EP 2095280 A2 | | 02-09-2009 |
| | | | KR 20090085651 A | | 07-08-2009 |
| | | | US 2008127027 A1 | | 29-05-2008 |
| | | | WO 2008057996 A2 | | 15-05-2008 |
| US 2005149902 | A1 | 07-07-2005 | CN 1661479 A | | 31-08-2005 |
| | | | EP 1530083 A2 | | 11-05-2005 |
| | | | JP 4524174 B2 | | 11-08-2010 |
| | | | JP 2005173595 A | | 30-06-2005 |
| | | | KR 20050043713 A | | 11-05-2005 |
| | | | TW 200523524 A | | 16-07-2005 |
| | | | US 2005149902 A1 | | 07-07-2005 |
| US 2005015233 | A1 | 20-01-2005 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- WO 2017186483 A1
- EP 17199764 A
- EP 18158745 A
- WO 2015018625 A